(19) Europäisches Patentamt
European Patent Office
Office européen des brevets

(11) Publication number: **0 434 318 A2**

# (12) EUROPEAN PATENT APPLICATION

(21) Application number: 90313684.4

(22) Date of filing: 14.12.90

(51) Int. Cl.5: **H01L 21/76, H01L 21/74, H01L 29/86**

(30) Priority: 18.12.89 US 452915

(43) Date of publication of application:
26.06.91 Bulletin 91/26

(84) Designated Contracting States:
**DE FR IT NL**

(71) Applicant: HONEYWELL INC.
**Honeywell Plaza
Minneapolis MN 55408 (US)**

(72) Inventor: **Johnson, Ralph H
211 Ridgeview Drive
Plano, Texas 75094 (US)**

(74) Representative: **Fox-Male, Nicholas Vincent
Humbert
Honeywell Control Systems Limited Charles
Square
Bracknell Berkshire RG12 1EB (GB)**

(54) **Low sheet resistance diffused contacts to buried diffused resistors using isolation regions and buried layer.**

(57) A device and method for using and making semiconductor device wherein leadouts and isolation regions are formed using the same process step. A buried layer is formed in the substrate of the semiconductor device which is used to isolate the leadouts from the grounded substrate. The isolation region and the leadouts are then diffused into the structure at the same time using the same diffusant.

Fig. 1

## LOW SHEET RESISTANCE DIFFUSED CONTACTS TO BURIED DIFFUSED RESISTORS USING ISOLATION REGIONS AND BURIED LAYER

### BACKGROUND OF THE INVENTION

This invention is directed toward the field of semiconductor devices and more specifically toward the area of semiconductor devices having isolation diffusions and buried circuit elements.

Generally, in a junction isolated, bipolar process, isolation between different circuits of an IC chip is provided by including an isolation region between the different circuits. This isolation region is usually comprised of silicon material having the same conductivity type as the substrate, and is physically in contact with the substrate. In many semiconductor devices, the substrate is electrically connected to ground. Because the substrate was tied to ground and thus the isolation region was tied to ground, the isolation regions could only be used to isolate different circuits on the chip.

### SUMMARY OF THE INVENTION

The present invention is a device and method which allows a leadout to be formed during a process step which creates the isolation regions. The leadout can be used to connect internal circuitry such as resistors, piezoresistors, or JFETS to external circuitry. The leadouts are separated from the substrate by a buried layer comprised of material having the opposite conductivity type from the isolation diffusion and substrate. By placing the buried layer between the leadouts and the substrate, the leadouts no longer have a path to ground. Further, since most bipolar processes already have a buried layer, this invention can be accomplished without additional processing steps by modifying the already existing masks to ensure that the buried layer is interposed between the substrate and isolation diffusion. Since separate leadouts to elements such as resistors, piezoresistors and JFETS no longer need to be made, process steps, time and money can be saved by implementing the inventive device and method.

### BRIEF DESCRIPTION OF THE DRAWINGS

Figure 1 is a top view of a device including the inventive structure and method.

Figures 2a-f show a side view along line 2-2 of the steps taken to build the structure of the inventive device.

Figure 3 is a view along line 3-3 of the structure of the inventive device.

Figure 4 is a schematic diagram of the present invention.

### DETAILED DESCRIPTION OF THE DRAWING

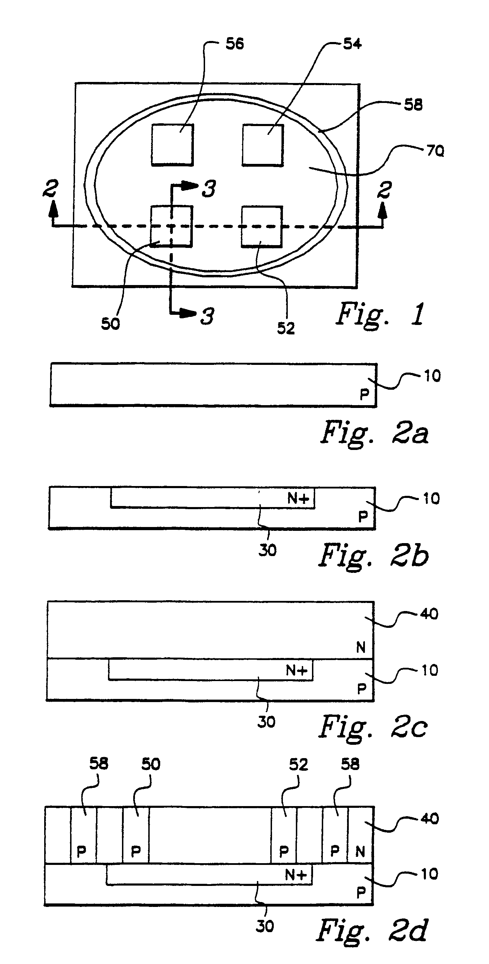

Referring now to Figure 1, thereshown is a top view of the inventive device 5. As shown, the top surface of the device has an oxide covering 70 and four leadouts 50, 52, 54 and 56, which may have contact cuts. These four leadouts serve as connection points to internal circuitry seen in Figures for external circuitry (not shown).

Turning now to Figures 2a-2f, thereshown is a side view of the device 5 taken along line 2-2, and the steps taken to build the device. Note that oxide 70 is not shown in these figures so that the figures will be more easily understood. In Figure 2a, a substrate 10 is formed out of a semiconductor material, preferably P-type monocrystalline silicon. Figure 2b shows a buried layer 30 being diffused into substrate 10, using a dopant to form an N+-type region. The buried layer of this chip is shown as extending beneath both leadouts 50 and 52 in Figure 2d, and may also extend under leadouts 54 and 56. When one buried layer 30 extends under all of the leadouts, it may be used subsequently as an etch stop. However, there may be four separate buried layers, each contacting only a single leadout.

Next, as shown in Figure 2c, an epitaxial layer 40 is grown on the upper surface of the buried layer 30 and on substrate 10. The epitaxial layer 40 in this embodiment will be of N-type silicon.

Once the epitaxial layer 40 is formed, leadouts 50, 52, 54 and 56 as well as isolation region 58 are diffused in epitaxial layer 40 as shown in Figure 2d (only leadouts 50 and 52 are shown). The leadouts are diffused so as to contact the buried layer 30. The isolation region 58 can be circular as seen in Figure 1 and can surround the other parts of the transducer, but is not required to do so. Both the isolation region 58 and leadouts 50, 52, 54 and 56 are formed using the same dopant during the same process step. It is to be noted that the leadouts contact the buried layer 30, and the isolation region 58, which is generally used to isolate circuit elements, contacts the grounded substrate.

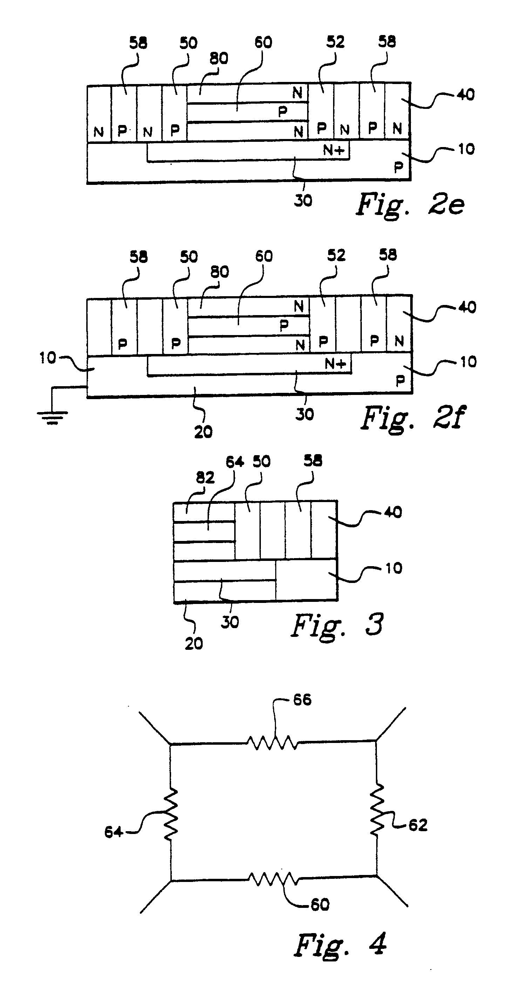

Next, in Figure 2e, resistor 60 is formed by diffusing a dopant into the epitaxial layer 40. The resistor 60 is diffused so that it comes into contact with leadouts 50 and 52. A protective overlayer 80 of a conductivity type opposite that of the resistor may be diffused into the resistor 60. It is to be noted that other circuit elements besides a resistor can use the inventive device and method.

To complete the device, an oxide 70 is formed on the upper surface of the epitaxial layer 40 and N layer 80. Areas over leadouts 50, 52, 54 and 56 can be left uncovered by the oxide to provide optional contact points. This can be seen in Figure 1.

Lastly, in Figure 2f, a diaphragm under the region of the resistor can be formed by etching away a portion of substrate 10. Region 20 represents an area of substrate 10 which has been etched away up to buried layer 30. An anisotropic etching process may be used to form the diaphragm whereby etching will cease once the etchant reaches the buried layer.

It is to be understood that a semiconductor device having an N substrate a P+buried layer, a P epitaxial layer, an N-type isolation diffusion and N-type resistor along with a P-type cap falls within the spirit of the present invention.

Also, instead of the piezoresistive pressure transducer disclosed, other devices having an isolation region which is adapted to be a leadout from a buried circuit element are intended to fall within the spirit of the invention.

Figure 3 shows that the structure is the same when viewed along line 2-2 as along line 3-3.

Figure 4 shows the schematic representation of the circuit of the present embodiment. In this embodiment, the circuit is a resistive bridge.

The foregoing has been a description of a novel and nonobvious way to make contacts to buried resistors in semiconductor devices. The applicant does not intend to be limited to the invention as described in the specification but intends to be solely limited by the claims appended hereto.

## Claims

1. A semiconductor device which provides isolation between circuit elements, the device characterised by :
   a substrate (10) having a first conductivity type and a first major surface ;
   a buried layer (30) having a second conductivity type and first doping level, said buried layer being formed in said substrate at said first major surface ;
   a second layer (40) having said second conductivity type and a second doping level, said second layer being formed on said first major surface, said second doping level being higher than said first doping level ;
   a circuit element (60) having two ends formed in said second layer ;
   at least two leadouts (50, 52) having said first conductivity type, each of said leadouts being physically in contact with different ends of said circuit element and being in contact with said buried layer ;
   an isolation region (58), said isolation region having said first conductivity type and being in contact with said substrate.

2. A device according to Claim 1 characterised in that said first conductivity type material is P type silicon, and said second conductivity type material is N+type silicon, and said circuit element is a resistor (60).

3. A device according to Claim 1 or 2 characterised in that :
   said at least one circuit element is a resistor ; and
   there are four resistors (60, 62, 64, 66) and four leadouts (50, 52, 54, 56), said resistors arranged in a resistor bridge wherein each resistor contacts exactly two of said leadouts.

4. A device according to any preceeding Claim characterised in that a portion of said substrate is etched away to form a diaphragm and support rim, said diagphragm and support rim being usable as a pressure transducer.

5. A piezoresistive transducer having a substrate (10), leadouts (58), and expitaxial layer (40), a buried layer (30), an isolation region (50, 52) and a resistor (60), wherein :
   said substrate, leadouts, isolation region and resistor are comprised of P type silicon materials ;
   said buried layer is comprised of N + type silicon material ;
   said buried layer is interposed between and in contact with said leadout and said substrate, said leadout further being in contact with said resistor ; and
   said isolation region is in contact with said substrate.

6. A method of constructing a piezoresistive transducer, characterised by the steps of :
   making a substrate (10) having a first conductivity type, said substrate having a first major surface ;
   forming a buried layer (30) having a second conductivity type in said major surface of said substrate ;
   forming a second layer (40) having said second conductivity type on said first major surface ;
   forming leadouts (50, 52) and an isolation region (58) having said first conductivity type, said leadout being formed in contact with said buried layer, said leadout further being in contact with a resistor, said isolation region being formed in contact with said substare ; and
   forming a circuit element (60) having said first conductivity type in said second layer, said circuit element being formed so as to contact at least two leadouts.

7. A method according to Claim 6 characterised by the further step of :

    etching a portion of the substrate to form a diaphragm, said etching stopping upon reaching the buried layer ;

    diffusing an overlayer into said circuit element, said overlayer having said second conductivity type.

8. A method according to Claim 6 or 7 characterised in that said regions having first conductivity type are formed by diffusing a group III type element into the device, thus constituting P-type material; and

    said regions having said second conductivity type are formed by diffusing a group V type element thus constituting N-type material.

56    54

58

70

2    3

2

50    3

52    Fig. 1

Fig. 1

P    10

Fig. 2a

N+    10

P

30    Fig. 2b

40

N

N+    10

P

30    Fig. 2c

58    50    52    58

P    P    P    P    N    40

N+    10

P

30    Fig. 2d

Fig. 2e

Fig. 2f

Fig. 3

Fig. 4